# EUROPEAN PATENT SPECIFICATION

(11) **EP 1 573 799 B1**
(45) Date of publication and mention of the grant of the patent: **27.01.2010**
(21) Application number: 02808338.4
(22) Date of filing: 20.12.2002
(51) Int. Cl.: H01L 25/065, H01L 23/485, H01L 21/98, H01L 21/60, H01L 21/768

(54) **THREE-DIMENSIONAL DEVICE FABRICATION METHOD**
HERSTELLUNGSVERFAHREN EINER DREIDIMENSIONALEN VORRICHTUNG
PROCEDE DE FABRICATION D'UN DISPOSITIF TRIDIMENSIONNEL

(43) Date of publication of application: 14.09.2005
(73) Proprietor: International Business Machines Corporation, Armonk, NY 10504 (US)
(72) Inventor: POGGE, H., Bernhard, Hopewell Junction, NY 12533 (US); YU, Roy, Poughkeepsie, NY 12601 (US)
(74) Representative: Ling, Christopher John
(86) International application number: PCT/US2002/041181
(87) International publication number: WO 2004/059720

(56) References cited:
- JP-A- 60 140 850
- JP-A- 60 160 645
- JP-A- 62 117 316
- US-A- 3 462 650
- US-A- 4 889 832
- US-A- 4 939 568
- US-A- 4 982 266
- US-A- 5 091 331
- US-A- 5 229 647
- US-A- 5 268 326
- US-A- 5 424 245
- US-A- 5 426 072
- US-A- 5 627 106
- US-A- 5 786 238
- US-A- 5 814 889
- US-A- 6 114 768
- US-A1- 2002 017 710
- US-B1- 6 444 560
- US-B1- 6 489 217

## Description

### Technical Field

This invention relates to the manufacture of very large-scale integrated semiconductor devices, and more particularly to methods for fabricating three-dimensional, vertically interconnected chips.

### Background Art

Microprocessor chips generally include a logic unit and cache memory.
If both the logic unit and the memory devices of a microprocessor are arranged in a two-dimensional (2-D) pattern, limitations on the physical size of the chip (imposed by poor process yields for large-area chips) may lead to restrictions on the amount of cache memory. The performance of the microprocessor may therefore be severely limited.

To address the problem of providing adequate cache memory for microprocessors (and more generally the problem of 2-D real estate on a chip), a number of researchers are exploring methods for building three-dimensional (3-D) integrated circuits. A typical 3-D fabrication process includes building devices on wafers which are then thinned to less than 20 µm; providing vertical interconnections through the wafers; stacking the wafers so that vertical connections are established between wafers at different levels; and bonding the wafers with a suitable material. See, for example, J.-Q. Lu et al., "Fabrication of via- chain test structures for 3D IC technology using dielectric glue bonding on 200 mm wafers," Materials Research Society ULSI XVII Conference Proceedings 151 (2002); P. Ramm et al., "Interchip via technology by using copper for vertical system integration," Materials Research Society Advanced Metallization Conference 159 (2002); and Rahman et al., "Thermal analysis of three-dimensional integrated circuits," IEEE International Interconnect Technology Conference Proceedings 157 (2001). Significant problems in the present state of the art of 3-D integration include (1) the need for reliable wafer bonding; (2) stringent wafer cleanliness and flatness requirements; (3) the need for reliable, low-resistance inter-wafer vertical connections; (4) stringent wafer-to-wafer lateral registration requirements; and (5) the need for efficient heat conduction through the 3-D device.

A process for making 2-D chip-to-chip interconnects is described in "Process for making fine pitch connections between devices and structure made by the process," U.S. Pat. No. 6,444,560 assigned to International Business Machines Corporation. As noted in this patent, chips having different functions and possibly of different materials may be connected through a wiring layer of polyimide using stud/via connections between the wiring layer and the respective chips. It is desirable to extend the techniques discussed in this patent to achieve 3-D chip-level and wafer-level integration.

### Disclosure of Invention

The present invention provides a method as claimed in claim 1.

The present invention addresses the above-described concerns by providing a method for fabricating a three-dimensional integrated device including a plurality of vertically stacked and interconnected wafers, in which the wafers may be reliably bonded together and the requirements for wafer flatness and highly precise alignment between wafers may be relaxed. Preferably, in order to vertically connect a first wafer and a second wafer, a via is formed in the first wafer extending from the front surface, the via being characterized by a lateral dimension at the front surface. Material is removed from the first wafer at the back surface thereof, thinning the wafer to less than 20 µm. An opening is formed in the back surface of the first wafer, thereby exposing the via; the opening has a lateral dimension greater than that of the via. A layer of conducting material is formed in this opening. A stud and a layer of bonding material are formed on the front surface of the second wafer, the studs projecting vertically therefrom. The stud is then aligned to the opening in the back surface of the first wafer; the wafers are bonded using the layer of bonding material, so that the stud makes electrical contact with the via. In order to interconnect three wafers, the second wafer is further provided with a via extending from the front surface of the wafer, and the second wafer is thinned by removing material from the second wafer at the back surface thereof. An opening is formed in the back surface of the second wafer, thereby exposing the via therein; this opening has a lateral dimension greater than the lateral dimension of the via. A layer of conducting material is formed in this opening. The third wafer has a layer of bonding material and a stud formed on the front surface thereof; the stud is aligned to the opening in the back surface of the second wafer.
The third wafer is then bonded to the second wafer using the layer of bonding material, so that the stud of the third wafer makes electrical contact with the via of the second wafer, with the stud of the second wafer, and with the via of the first wafer.

Preferably, the vias in the respective wafers need not extend vertically from the front surface to the back surface of the wafers. A conducting body, provided in the wafer beneath the device region and extending laterally, may connect the via with the metallized opening in the back surface. Accordingly, the conducting path through the wafer may be led underneath the devices thereof. The bonding layer is preferably a thermoplastic material, and in particular may be polyimide. This permits wafers to be bonded with less stringent requirements regarding flatness and cleanliness.

Additional openings may be formed in the back surface of the first wafer, to connect to additional studs on the front surface of the second wafer, where the additional openings and studs are insulated from the vias. These additional connections serve as vertical heat conduction pathways between the wafers. The present invention therefore realizes 3-D vertical integration with both reliable electrical connections and improved heat conduction between wafers.

### Brief Description of Drawings

Figures 1A-1I are schematic illustrations of steps in a fabrication process for a 3-D integrated device, in accordance with a first embodiment of the invention.
Figures 2A-2F are schematic illustrations of steps in a fabrication process for a 3-D integrated device, in accordance with a second embodiment of the invention.
Figure 3 illustrates a vertical interconnect between wafers extending laterally under a device region of the wafer, in accordance with an embodiment of the invention.
Figures 4A-4C illustrate a fabrication process for improving heat conduction in a 3-D integrated device, also in accordance with an embodiment of the invention.
Figure 5 illustrates a completed microprocessor device including a logic unit and a 3-D stacked memory unit, the memory unit being fabricated in accordance with an embodiment of the invention, where the logic and memory units are connected in a 2-D interconnection scheme using C4 technology on a multichip module (MCM).
Figure 6 illustrates a completed microprocessor device including a logic unit and a 3-D stacked memory unit, the memory unit being fabricated in accordance with an embodiment of the invention, where the logic and memory units are connected in a 2-D transfer and join (T&J) interconnection scheme using stud/via connections.
Figure 7 illustrates a completed microprocessor device including a logic unit and memory units, where all the units are vertically integrated in accordance with an embodiment of the invention.

### Best Mode for Carrying Out the Invention

In accordance with the present invention, a plurality of thinned wafers with devices formed thereon may be stacked and vertically interconnected. In the embodiments described herein, a three-level stack is fabricated and connected; it will be appreciated that this is for illustration purposes only, and that the process may be adapted to more or fewer than three levels. The 3-D, vertically integrated device may be constructed in two ways, as detailed below.

### (1) Top-down wafer stack process

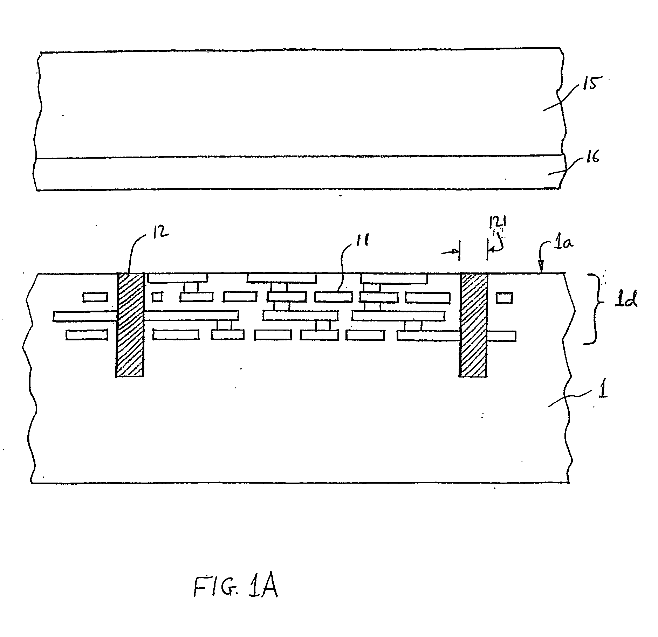

Figure 1A shows in cross-section a wafer 1 having devices and several levels of high-density interconnection wiring 11 (typically Cu) in a region 1d of the wafer near the front surface 1a thereof. Metallized vias 12 are formed in the wafer, extending below the region 1d of devices and lateral interconnects; these vias will become part of the vertical through-connections after wafer 1 is thinned. Vias 12 are typically formed by etching holes in wafer 1, forming a layer of liner material on the sides and bottom of the holes, and filling the holes with metal (preferably copper). The depth of the vias 12 is less than the eventual thickness of wafer 1 after thinning; thus, if the wafer after thinning is about 10 µm thick, the vias are less than 10 µm deep. The diameter of the vias 121 must be chosen to balance heat conduction and space concerns. A diameter of approximately 1 µm consumes minimal space on the wafer surface while providing acceptable heat conduction through the wafer; a smaller via diameter may be used but may not be adequate for conducting heat through the vertical wafer stack.

For convenience of illustration, via 12 is shown extending straight downward with a uniform diameter into a region of the wafer below that of the devices. Size requirements for the vias may in practice be substantially relaxed below region 1d. Other arrangements are possible which involve the through-connections extending laterally underneath the devices, as discussed in more detail below.

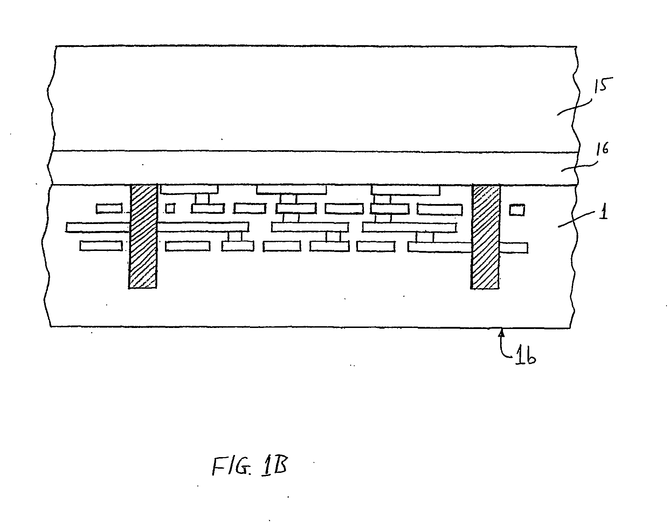

In order to facilitate handling of the thinned wafer, a handling plate (typically of glass) 15 is attached to the front surface 1a of the wafer. The wafer 1 and plate 15 are bonded together using a layer 16 of a thermoplastic bonding material, preferably polyimide.
With the handling plate 15 attached to the wafer 1, the wafer is thinned by grinding or polishing the back side 1b (see Figure 1B). The resulting thickness of wafer 1 is less than 20 µm, preferably about 10 µm. As shown in Figure 1B, the thinning process stops short of exposing the bottom of vias 12.

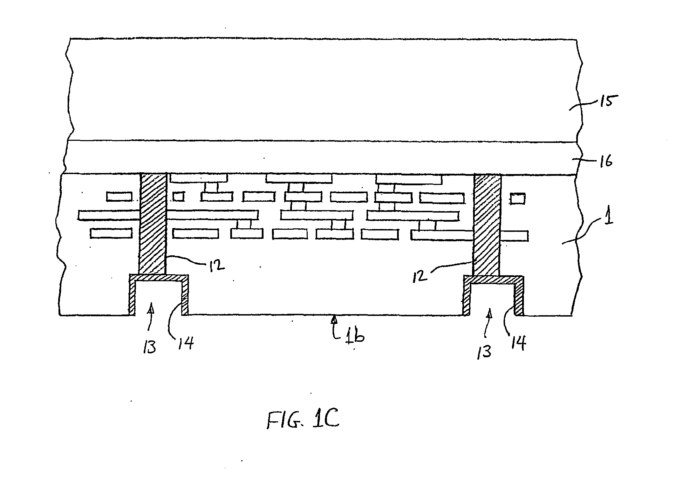

Openings 13 are then etched in the back surface 1b of the wafer, exposing the bottom of vials 12 (Figure 1C). The metal in the via may itself serve as an etch stop for this process; alternatively, an etch stop layer may be provided at another portion of the wafer (not populated by devices) to provide control for this process. It should be noted that openings 13 have a greater diameter than that of vias 12. Although numerous arrangements of vias are possible (as discussed further below), the openings at the back surface 1b are generally larger than the vias at the front surface 1a.

The interior surfaces 14 of opening 13 are then coated with metal (preferably by sputtering) to make contact with the bottom end of the corresponding via 12, so that a conducting path is formed through wafer 1. It should be noted that opening 13 has a diameter greater (typically two times greater) than that of the corresponding via 12; this is to facilitate vertical connection with another wafer.

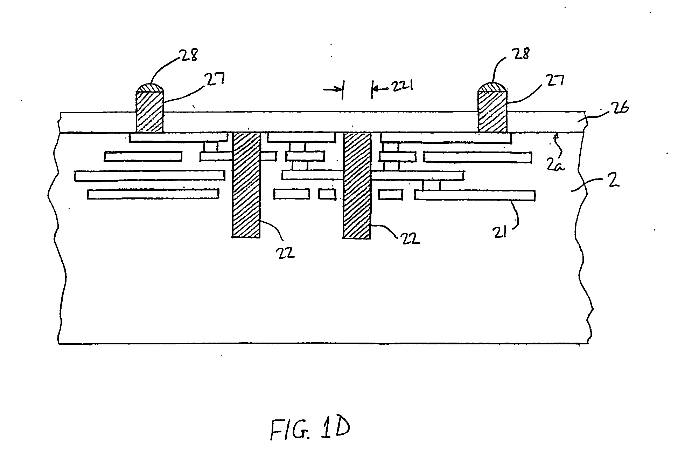

Figure 1D shows a second wafer 2 which is to be vertically integrated with wafer 1. Wafer 2 has devices and interconnect wiring 21 formed thereon, similar to wafer 1. In addition, metallized vias 22 (typically filled with copper) extend downward into wafer 2; vias 22 have a lateral dimension 221 at surface 2a.. A layer of polyimide 26 is deposited on the front surface 2a of wafer 2. Studs 27 are formed on surface 2a, extending above the top surface of layer 26 a distance which typically is 5 µm or less. Studs 27 may be formed of Ni, Cu, Ni-plated Cu, W or some other metal or combination of metals. A layer 28 of low- melting-point alloy material is deposited on the surface of the stud; this facilitates formation of an electrical connection during the process of vertically joining wafers 1 and 2. The alloy material is typically 90/10 Pb/Sn solder, 2 µm or less thick; alternative alloy materials include Au/Sn and Sn/Ag. The alloy material may be subjected to a thermal reflow process so that layer 28 acquires a rounded shape, as shown in Figure 1D; this facilitates alignment of the studs on wafer 2 to corresponding openings in wafer 1. The studs extend electrical connections vertically upward from the devices of wafer 2, while the vias 22 extend electrical connections vertically downward.

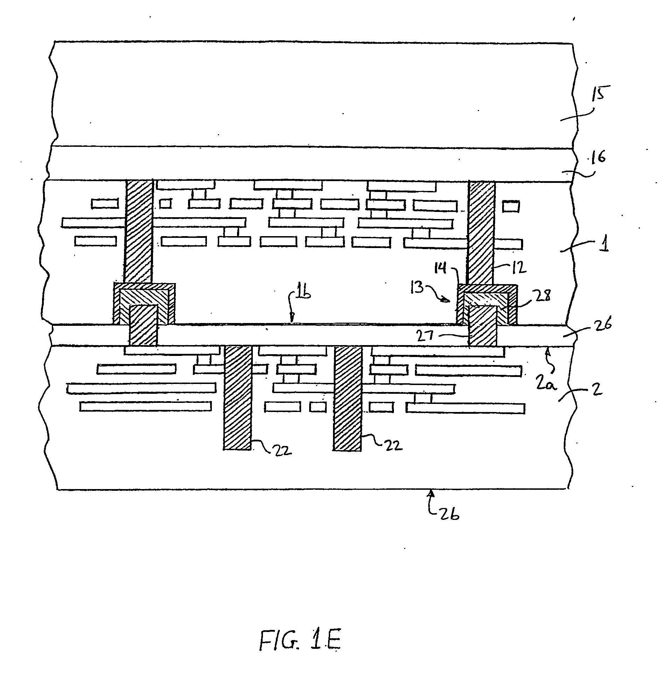

Wafer 1 (attached to handling plate 15) is then attached to wafer 2 using a bonding and lamination process. As shown in Figure 1E, studs 27 on wafer 2 are brought into registration with openings 13 on wafer 1, with the back surface 1b of wafer 1 in contact with the front surface of polyimide layer 26. The lamination process is performed at a temperature and pressure sufficient to (1) ensure bonding between wafer 1 and layer 26 and (2) ensure electrical contact between stud 27 and metal 14 (and thence to via 12). Depending on the materials used, the temperature may be in the range 200°C - 400°C and the pressure may be in the range 10 psi - 200 psi. As shown in Figure 1E, the bonding and lamination process causes the solder 28 to flow so that solder either partially or completely fills opening 13.

It should be noted that the openings 13 have a greater diameter than the studs 27, and are thus able to accommodate imprecision in the lateral placement of wafer 2 relative to wafer 1. Furthermore, it should be noted that surfaces 1b and 2a are not directly in contact, but have layer 26 between them. Polyimide layer 26 has sufficient thickness to cover small surface particles, fill in minor surface defects, or accommodate differences in flatness of the two wafers. Accordingly, layer 26 plays an important role in ensuring a reliable mechanical bond between the wafers, while the stud/via connection 27-28-14-12 provides a reliable vertical electrical connection.

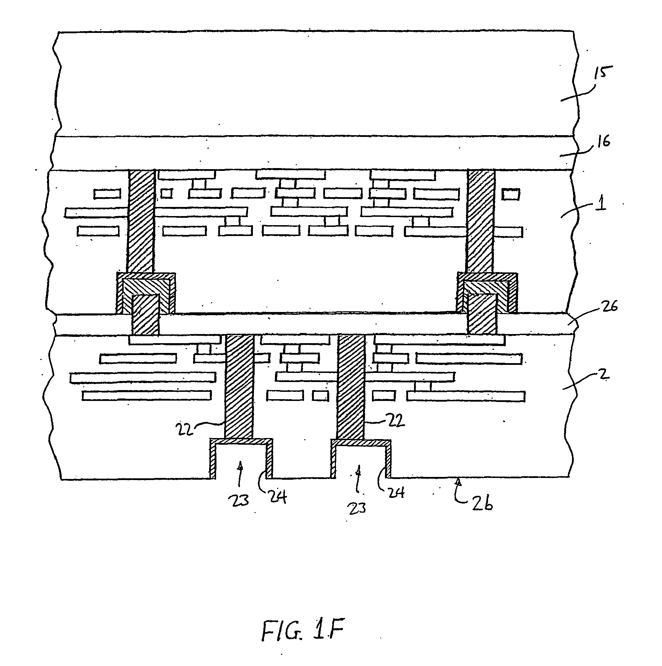

Wafer 2 (now bonded to wafer 1) is then thinned to less than 20 µm, preferably about 10 µm. As shown in Figure 1F, openings 23 are formed in the back surface 2b of wafer 2, exposing the bottom of vias 22. The interior surfaces of openings 23 are coated with metal. 24 (preferably by sputtering as with wafer 1), to provide electrical connection to another wafer 3.

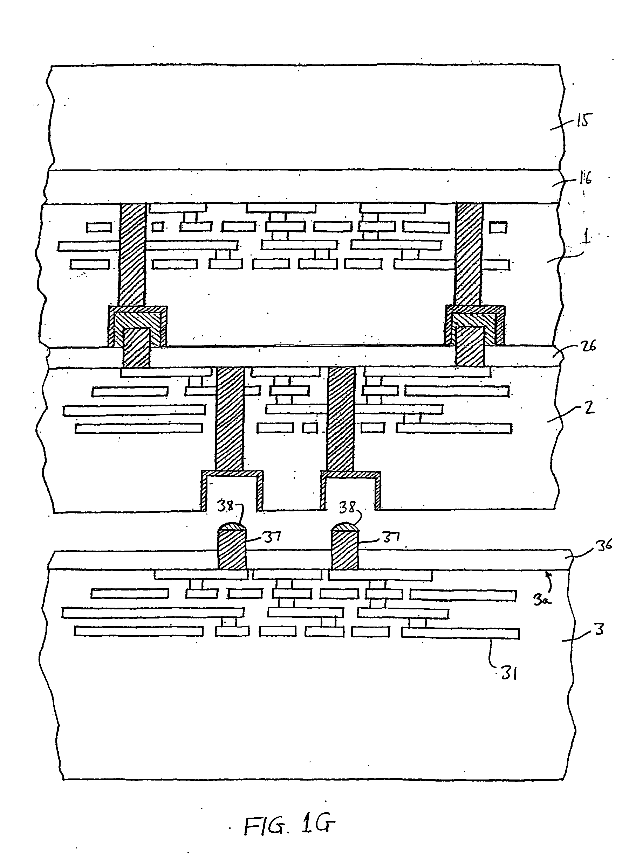

Figure 1G illustrates preparation of wafer 3 for bonding to wafers 1 and 2. Wafer 3 also has devices and interconnection wiring 31 near the front surface thereof. In order to make electrical contact with the back side of wafer 2, studs 37 are formed on the front side 3a of wafer 3. Studs 37 have an alloy material 38 on the surface thereof, similar to studs 27 and alloy material 28 respectively on wafer 2. A polyimide layer 36 is also deposited on surface 3a, similar to layer 26. In this illustration, wafer 3 is the final wafer of the vertical stack to be bonded; accordingly, wafer 3 is not thinned (in order to provide mechanical strength for the stack) and does not require through-wafer vias.

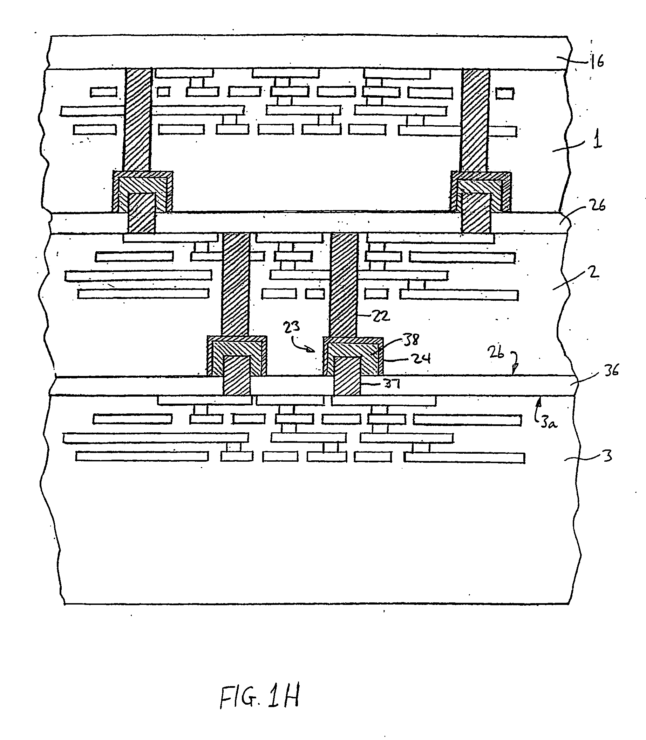

Figure 1H shows the result of the bonding and lamination process for wafer 3. Studs 37 are brought into electrical contact with via 22, as a result of alloy material 38 filling opening 23 and bonding to metal layer 24. Polyimide layer 36 is bonded to surface 2b of wafer 2, similarly to layer 26 between wafers 1 and 2. Since the unthinned wafer 3 provides mechanical strength to thinned wafers 1 and 2, the handling plate 15 is no longer required and may be removed at this point. This may conveniently be done by laser ablation; that is, if plate 15 is transparent to ablating radiation, a laser may be used to ablate the interface between plate 15 and layer 16, thereby detaching the plate.

The vertically interconnected wafer stack 1-2-3 may then have external connections attached, as shown in Figure 11. Figure 11 shows, for example, C4 technology used to connect the vertical stack to other components in a larger device. Openings 40 are formed in layer 16 to expose the metallized vias 12 of wafer 1; metal pads 41 are then deposited in the openings. C4 solder bumps 42 are then formed on these pads, using (for example) solder mask techniques known in the art. The completed vertically integrated device 100 is then ready to be bonded to C4 pads on a multichip module (MCM) or the like.

It should be noted that the internal structure of wafers 1, 2 and 3 has been illustrated only schematically; in fact, these wafers may be fabricated by a variety of methods and may have different functions. For example, all three wafers may have cache memory devices; wafers 1 and 2 may have memory while wafer 3 has logic devices; one or more of the wafers may incorporate micro-electromechanical systems (MEMS); and so forth.

The present inventors have found that successful wafer-level vertical integration is ensured by (1) thinning wafers to about 10 µm, to minimize vertical heat-transfer problems in the vias; (2) using polyimide as a thermoplastic bonding material, to relax wafer flatness and cleanliness requirements; and (3) using stud/via connections where the backside via opening is substantially larger than the stud, to relax lateral registration requirements.

### (2) Bottom-up wafer stack process

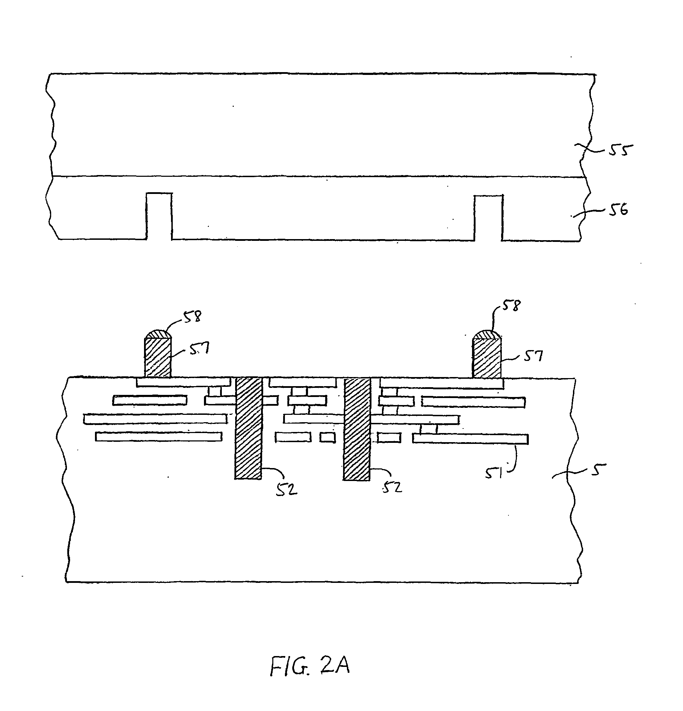

An alternative process for bonding wafers in a vertical stack is illustrated in Figures 2A-2E; this process will be detailed for three wafers but, as noted above, may be adapted to more or fewer wafers. A wafer 1 is first prepared in accordance with the process shown in Figures 1A-1C; this wafer thus is thinned to about 10µm, has metallized vias 12 with openings 13 on the back surface, and has a handling plate 15 attached to the front surface with a polyimide layer 16.

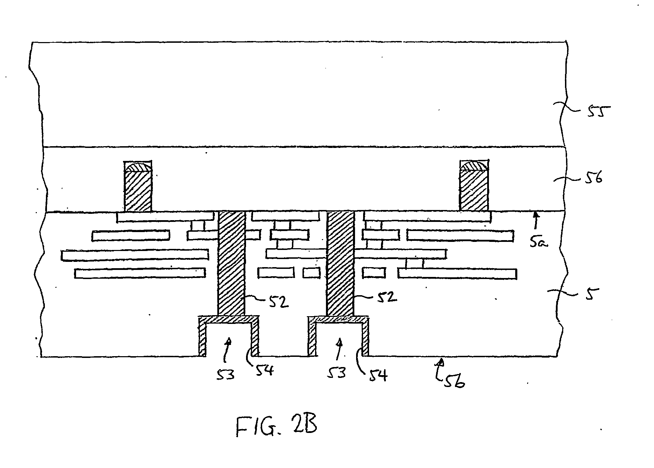

A second wafer 5, having lateral interconnect wiring 51, is then prepared as shown in Figure 2A. Wafer 5 has both vias 52 and studs 57 with alloy material 58, similar to wafer 2 in the process described above (compare Figure 1D). A handling plate 55 is provided for wafer 5; plate 55 is covered with a polyimide coating 56 which is patterned to accommodate studs 57. Wafer 5 is then bonded to handling plate 55, which permits the wafer to be thinned (Figure 2B). Openings 53 are formed in the backside 5b of the thinned wafer, and the interior surfaces thereof are coated with a metal layer 54 as described previously.

Since wafers 1 and 5 each have respective handling plates 15 and 55, they may be prepared, bonded and thinned separately.

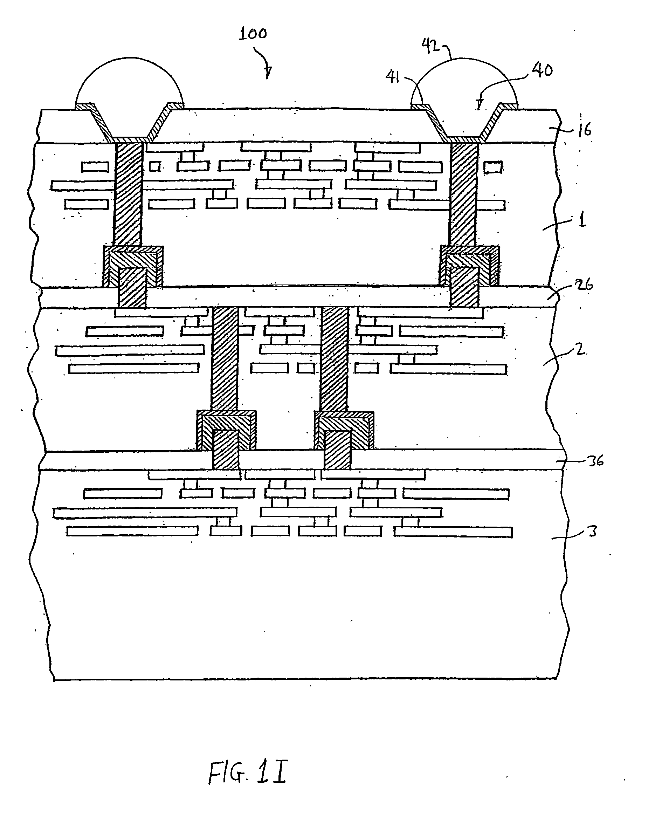

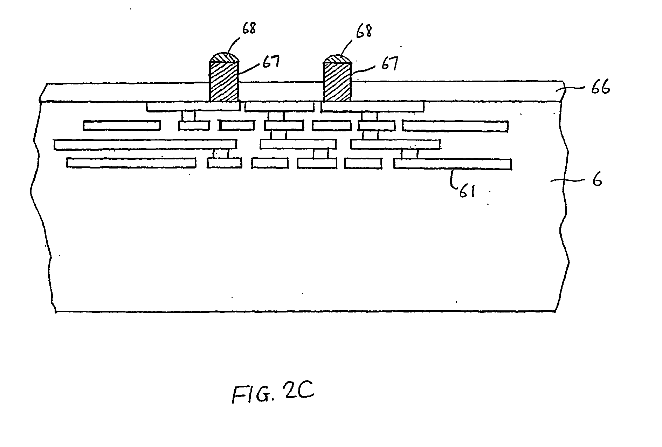

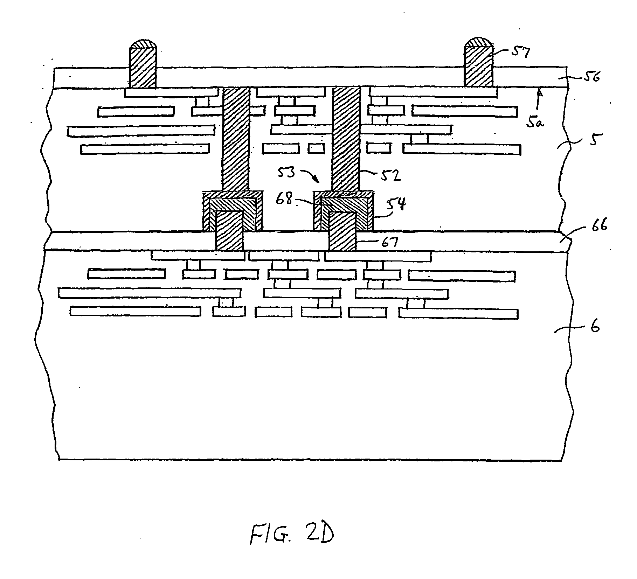

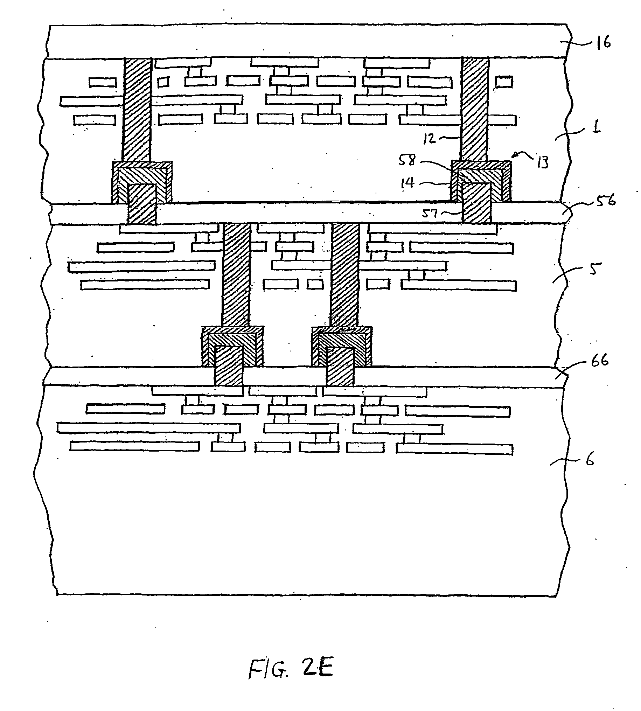

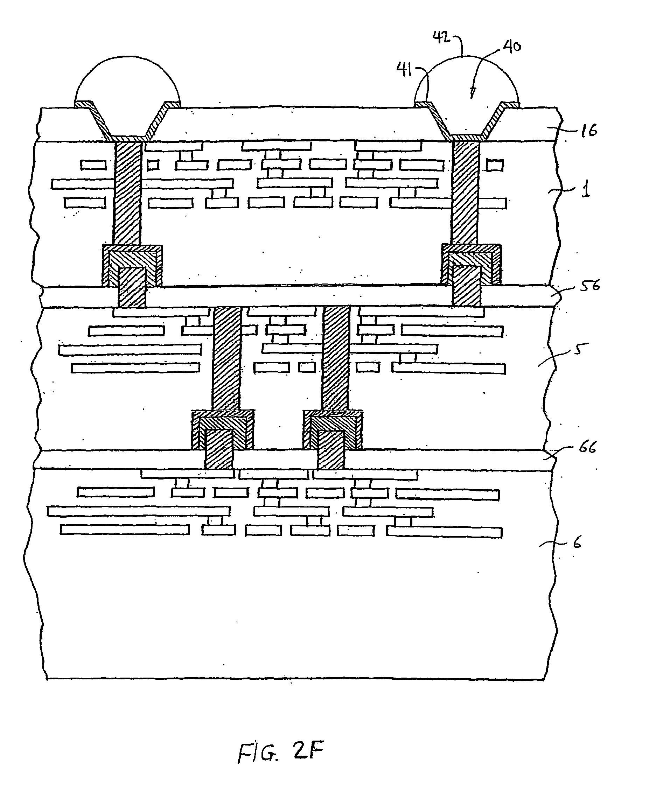

A third wafer 6, having lateral interconnect wiring 61, is prepared as shown in Figure 2C. This wafer (similar to wafer 3 as shown in Figure 1G) has a polyimide layer 66 on its front surface and studs 67, with alloy material 68 on the surfaces thereof, for making vertical electrical connections to the other wafers. Studs 67 protrude from layer 66 a sufficient distance to make contact with the metal layer 54 on wafer 5 (that is, about 5 µm). Wafers 5 and 6 are then bonded and laminated together, as shown in Figure 2D. Since wafer 6 is not thinned, handling plate 55 is not required after the bonding process and is therefore removed. At this point layer 56, on the front surface 5a of wafer 5, is reduced in thickness so as to expose about 5 µm in height of studs 57. Studs 57 are then ready for bonding to metal layer 14 of wafer 1. The result of this bonding process, wherein stacked wafers 5 and 6 are joined to wafer 1, is shown in Figure 2E; alloy material 58 fills the opening 13 in thinned wafer 1, making electrical contact with metal layer 14 and thence to via 12. After wafers 5 and 6 are bonded to wafer 1, handling plate 15 is no longer required and may be removed, thereby exposing layer 16. Layer 16 may then have openings 40 formed therein and metal pads 41 and C4 solder bumps 42 formed to connect to vias 12 (Figure 2F; compare Figure 1I).

It will be appreciated that the above-described techniques for stacking a plurality of thinned chips, and incorporating vertical interconnects from chip to chip, greatly increases chip content and function without increasing its areal (two-dimensional) size. These processes are particularly attractive for chips having the same content, since each of the thinned and stacked chips will then have the same size. This in turn makes the overall processing for the device significantly simpler and more economical. It should be noted that these processes permit wafer-level chip-to-chip interconnection, thus making the process of creating 3-D chips significantly less expensive when compared to single-chip vertical placement, bonding and interconnection processes. In contrast to previously described vertical interconnection schemes, the chip-to-chip interconnections in the present invention are not made along the sides of the chip, but are formed directly through the chip.

It is noteworthy that with the reduced thickness of the stacked wafer (about 10 µm), the interconnection length between chips (e.g. between cache memory units) is much smaller than in a 2-D arrangement of such chips. This gives the added benefit of improved device performance, besides the savings of two-dimensional space.

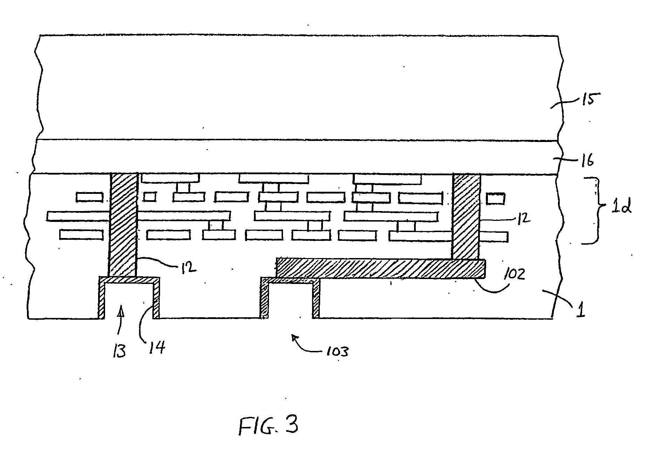

In Figures 1A-1I and 2A-2F, the vias are shown extending straight downward through the wafers and with a uniform diameter, for convenience of illustration. It is not necessary for the vertical chip-to-chip interconnects to have a small diameter through the full thickness of the wafer, or even for the entire 10 µm thickness of the thinned wafer. For example, as shown in Figure 3, wafer 1 may be prepared with a large metal region 102 embedded therein. The vertical interconnect may then include a vertical wire 12 with a small diameter (less than 1 µm) to save space as it extends through the device area 1d of the wafer, and a much larger metal region 102 extending laterally underneath the device area and connecting with the metallized interior surface of backside opening 103. Opening 103 is thus separated laterally from via 12 in accordance with the lateral extent of region 102. This arrangement minimizes the space needed for the vertical interconnect in the device area while at the same time reducing the resistance of the interconnect. In addition, it should be noted that this arrangement makes it possible to locate interconnect areas directly underneath device areas on the wafer (for example, interconnection to another wafer through opening 103 located directly underneath devices in region 1d). This in turn permits flexibility in the size and location of openings 103, and thus further relaxes the need for precise alignment between wafers (in this example, between wafers 1 and 2).

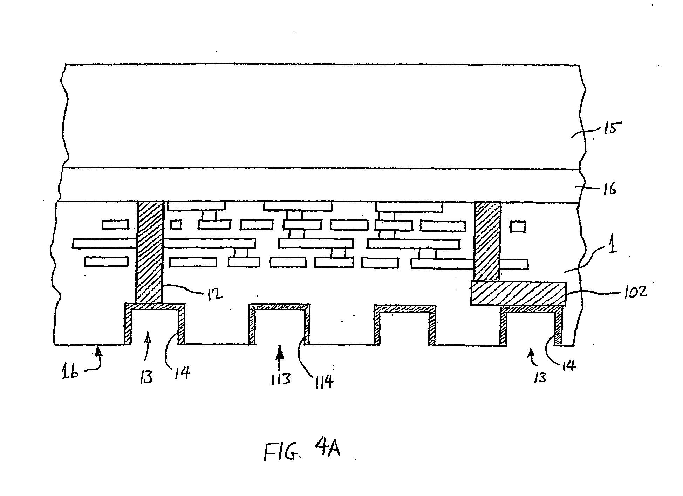

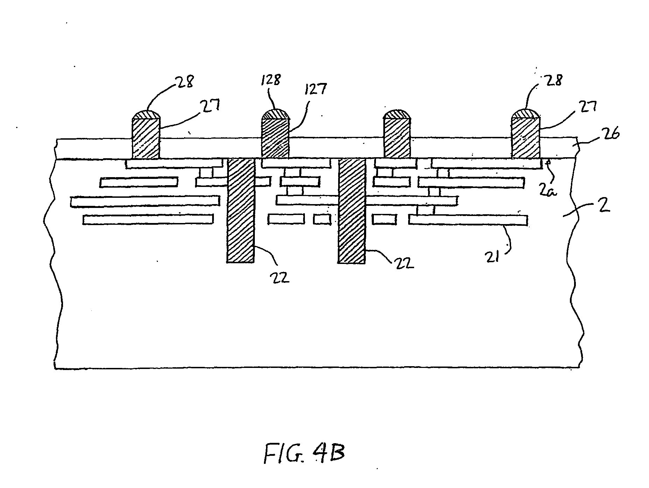

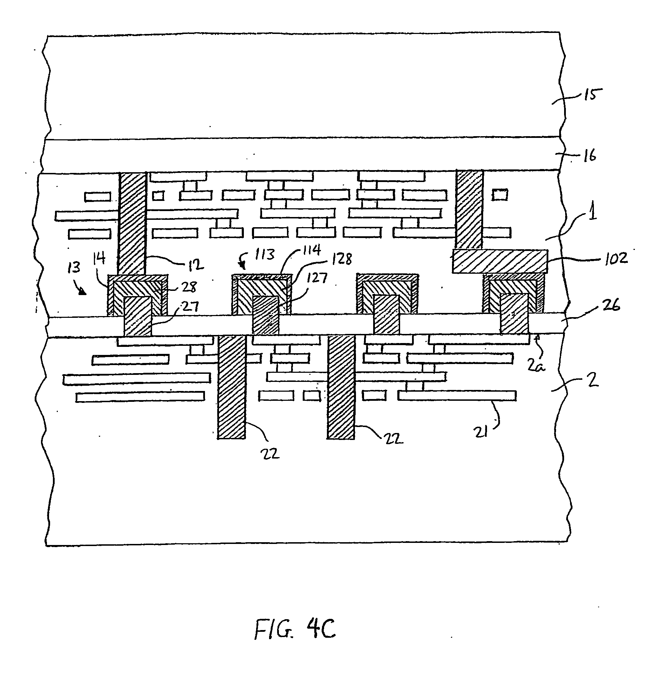

The metallized vertical connections between wafers may be used for heat conduction as well as for electrical signals. For example, as shown in Figure 4A, an electrical pathway is routed laterally under the device region of wafer 1 to provide additional space between electrical connection openings 13 on the back side 1b of the wafer. Additional openings 113 are formed in the wafer surface and have their interior surfaces 114 coated with metal, similar to openings 13 and metallization 14. (Openings 13, 113 may be formed in the same process step; similarly for metallization 14, 114.) The additional openings 113 do not form part of an electrical connection, but serve to provide a pathway for heat conduction through the wafer stack. Additional studs 127, capped with low melting point alloy material 128, are formed on the front surface 2a of wafer 2, as shown in Figure 4B. When the wafers are bonded together in the above-described processes, studs 127 connect with the metal 114 in openings 113, to form a metallized heat conduction pathway between wafers 1 and 2 (see Figure 4C). As shown in Figure 4C, studs 127 may or may not connect electrically with vias 22 or studs 27; no electrical signal is carried to the front surface of wafer 1.

Although the heat conduction pathway in Figures 4A-4C is shown as being formed between wafers 1 and 2, it will be appreciated that this technique may be used to improve heat conduction between any of the wafers in the stack in either of the above- described integration processes (between wafers 2 and 3 shown in Figure 1H; between wafers 5 and 6 shown in Figure 2D; and so forth).

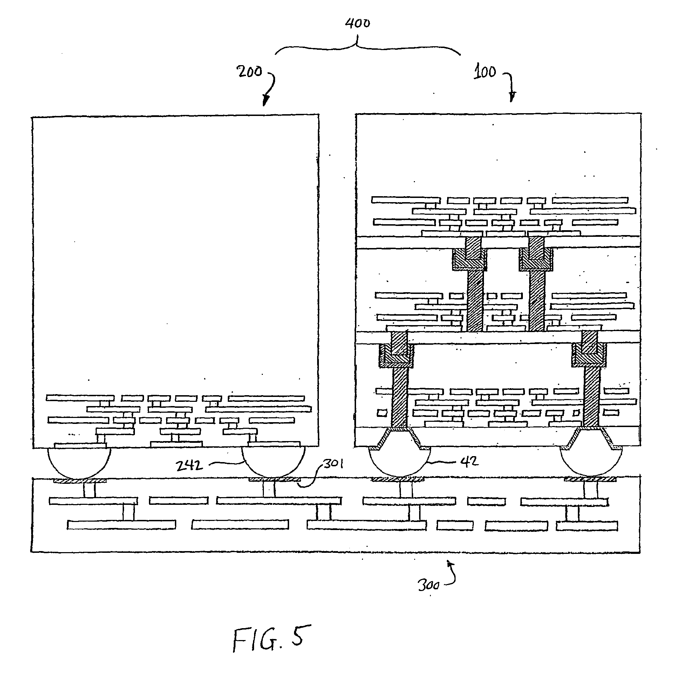

Figure 5 illustrates a device 400 having a vertically integrated stack (e.g. a cache memory unit) 100 which is laterally connected to a chip (e.g. a logic unit) 200, using C4 connections to a multichip module (MCM) 300. The vertical memory stack and logic chip have C4 solder bumps 42 and 242 respectively which are bonded to C4 pads 301 on the MCM. The MCM 300 may then be integrated into a larger and more complex device.

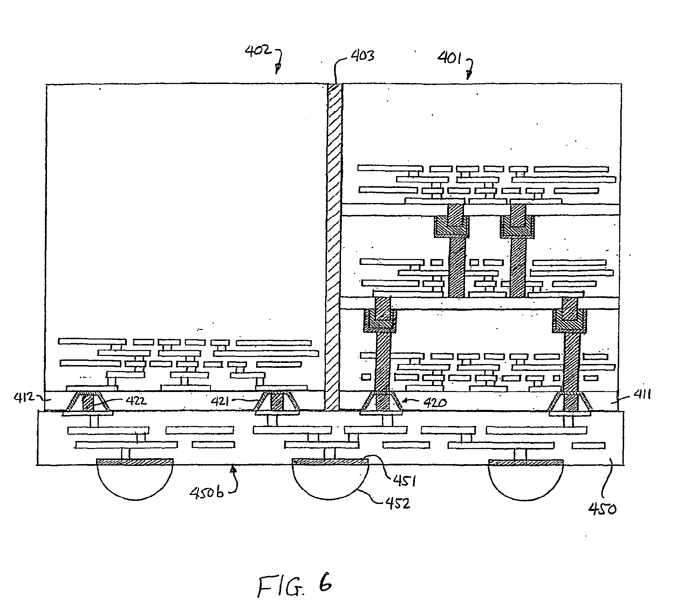

A closer connection between the cache memory and logic units may be realized by using stud/via connections, as shown in Figure 6. The cache memory unit 401 is prepared according to one of the processes described above, but with metallized vias 420 in polyimide layer 411 (compare Figures 1I and 2F). Similar vias are formed in polyimide layer 412 on logic unit 402. An insulating layer 450 (of a low-k dielectric material, an oxide, or polyimide), having interconnect wiring embedded therein, has studs 422 formed thereon to match the locations of the vias. Layer 450 may be built up on a handling plate (not shown), with units 401 and 402 then brought into alignment with the studs 422; after a bonding process in which studs 422 are connected with metal pads 421 in the vias, the handling plate is removed from surface 450b. The gap 403 between units 401 and 402 may be filled with a suitable material (e.g. polyimide) for increased mechanical stability. The combined device (now including memory unit 401, logic unit 402, and interconnect layer 450) may then have C4 pads 451 and C4 solder bumps 452 formed on surface 450b, to create an external connection for the device.

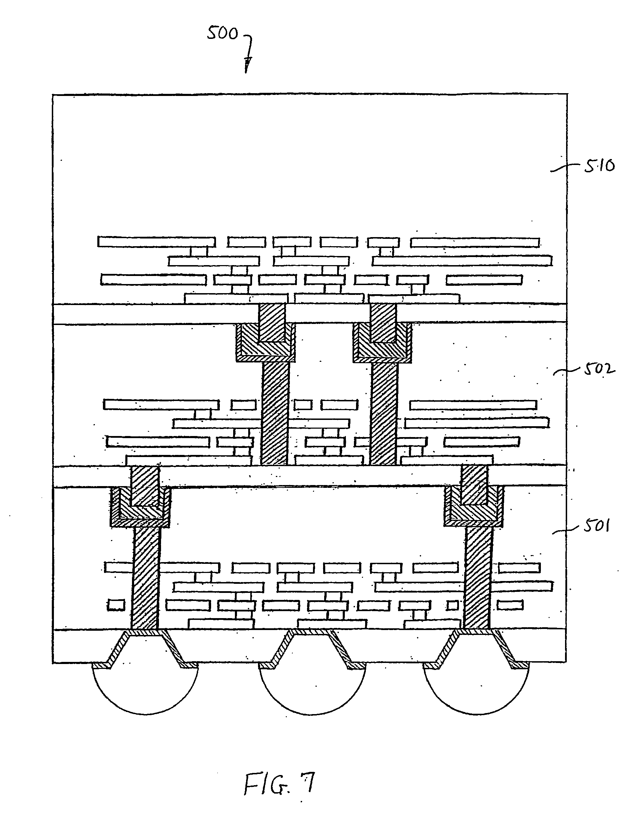

Alternatively, in a device incorporating cache memory and a logic unit, both may be integrated in a vertical stack, as shown in Figure 7. Combined device 500 includes a logic unit 510 integrated with cache memory chips 501 and 502. In this arrangement, logic unit 510 is at the top of the stack, where it is easiest to remove excess heat.

It will be understood that units 100, 200, 401, 402, 500 in Figures 5-7 need not be merely logic and/or memory devices, but may in fact be any of a wide variety of devices. Accordingly, different device technologies may easily be combined in a 3-D integrated device using the process of the present invention.

### Industrial Applicability

The present invention is generally applicable to semiconductor device structures where high areal density of devices is required. The invention is particularly applicable to chips requiring large memory cache contents which cannot be fabricated with presently available methods due to reticle size limitations or due to limited process yields.

## Claims

1. A method for fabricating a three-dimensional integrated device including a plurality of vertically stacked and interconnected wafers, the method comprising the steps of:
providing a first wafer (1) having a front surface (1a) and a back surface (1b) the first wafer having devices formed in a region (1d) adjacent to the front surface thereof;
forming a blind via (12) in the first wafer extending from the front surface, the via having a lateral dimension (121) at the front surface;
removing material from the first wafer at the back surface (1b) thereof;
forming an opening (13) in the back surface of the first wafer, thereby exposing said via (12), the opening having a lateral dimension greater than said lateral dimension of the via;
forming a layer of conducting material (14) in said opening making electrical contact with said via;
providing a second wafer (2) having a front surface (2a) and a back surface (2b), the second wafer having devices formed therein adjacent to the front surface thereof;
forming a stud (27) on the front surface of the second wafer;
forming a layer of bonding material (26) on the front surface (2a) of the second wafer, the studs projecting vertically there through;
aligning the stud (27) to the opening (13) in the back surface of the first wafer; and
bonding the second wafer to the first wafer using the layer of bonding material (26), so that the stud is brought into registration with said opening and makes electrical contact with said layer of conducting material and said via.

2. A method according to claim 1, further comprising the steps of:
forming a via (22) in the second wafer (2) extending from the front surface thereof (2a), the via being **characterized by** a lateral dimension (221) at the front surface (2a);
removing material from the second wafer at the back surface (2b) thereof;
forming an opening (23) in the back surface (2b) of the second wafer, thereby exposing the via (22) therein, said opening (23) having a lateral dimension greater than said lateral dimension (221) of the via (22);
forming a layer of conducting material (24) in said opening;
providing a third wafer (3) having a front surface (3a), the third wafer having devices formed therein adjacent to the front surface thereof;
forming a stud (37) on the front surface (3a) of the third wafer;
forming a layer of bonding material (36) on the front surface (3a) of the third wafer, the studs projecting vertically therefrom;
aligning the stud (37) to the opening (23) in the back surface of the second wafer; and
bonding the third wafer to the second wafer using the layer of bonding material (36), so that the stud (37) of the third wafer makes electrical contact with the via (22) of the second wafer, with the stud (27) of the second wafer, and with the via (12) of the first wafer.

3. A method according to claim 1 or claim 2, **characterized in that** said step of removing material causes the wafer to have a thickness of less than 20µm.

4. A method according to claim 1 or claim 2, further comprising the step of attaching a handling plate (15) to the front surface (1a) of the first wafer (1) using a layer of bonding material (16).

5. A method according to any preceding claim, further comprising the step of forming a conducting body (102) in one of the first wafer (1) and the second wafer (2) and connecting to the via (12/22) in the wafer, the conducting body extending laterally under the devices of the wafer, and
**characterized in that** the opening (103) in the back side of the wafer is separated laterally from the via in accordance with the lateral extent of the conducting body (102).

6. A method according to any preceding claim, further comprising the steps of:
forming an additional opening (113) in the back surface of the first wafer;
forming an additional layer of conducting material (114) in said additional opening;
forming an additional stud (127) on the front surface of the second wafer; and
aligning the additional stud (127) to the additional opening (113) in the back surface of the first wafer;
and **characterized in that** said step of bonding the second wafer to the first wafer forms a connection between the additional stud (127) and the additional layer of conducting material (114) for conducting heat between the second wafer and the first wafer.

7. A method according to claim 6, **characterized in that** the additional layer of conducting material (114) is electrically insulated from the via (12).

8. A method according to claim 2, further comprising the steps of:
forming an additional opening in the back surface of the second wafer;
forming an additional layer of conducting material in said additional opening;
forming an additional stud on the front surface of the third wafer; and
aligning the additional stud to the additional opening in the back surface of the second wafer;
and **characterized in that** said step of bonding the third wafer to the second wafer forms a connection between the additional stud and the additional layer of conducting material for conducting heat between the third wafer and the second wafer.

9. A method according to any preceding claim, **characterized in that** said bonding material is a thermoplastic material.

10. A method according to any of claims 1-9, further comprising the step of attaching the three-dimensional integrated device (100) to a multichip module (300).

## Patentansprüche

1. Verfahren zur Herstellung einer dreidimensionalen integrierten Einheit, welche mehrere vertikal gestapelte und verbundene Wafer umfasst, wobei das Verfahren die folgenden Schritte umfasst:
Bereitstellen eines ersten Wafers (1), welcher eine vordere Fläche (1a) und eine hintere Fläche (1b) aufweist, wobei der erste Wafer Einheiten aufweist, die in einem Bereich (1d) in Nachbarschaft zu seiner vorderen Fläche ausgebildet sind;
Bilden einer Sackloch-Durchkontaktierung (12) in dem ersten Wafer, welche sich von der vorderen Fläche aus erstreckt, wobei die Durchkontaktierung eine Querabmessung (121) an der vorderen Fläche aufweist;
Entfernen von Material von dem ersten Wafer an dessen hinterer Fläche (1b);
Bilden einer Öffnung (13) in der hinteren Fläche des ersten Wafers, wodurch die Durchkontaktierung (12) frei gelegt wird, wobei die Öffnung eine Querabmessung aufweist, die größer als die Querabmessung der Durchkontaktierung ist;
Bilden einer Schicht aus leitfähigem Material (14) in der Öffnung, welche mit der Durchkontaktierung in elektrischem Kontakt steht;
Bereitstellen eines zweiten Wafers (2), welcher eine vordere Fläche (2a) und eine hintere Fläche (2b) aufweist, wobei der zweite Wafer Einheiten aufweist, die darin in Nachbarschaft zu dessen vorderer Fläche ausgebildet sind;
Bilden eines Stiftes (27) auf der vorderen Fläche des zweiten Wafers;
Bilden einer Schicht aus einem Klebematerial (26) auf der vorderen Fläche (2a) des zweiten Wafers, wobei die Stifte vertikal durch diese hindurch ragen;
Ausrichten des Stiftes (27) an der Öffnung (13) in der hinteren Fläche des ersten Wafers; und
Kleben des zweiten Wafers an den ersten Wafer unter Verwendung der Klebematerial-Schicht (26), derart, dass der Stift mit der Öffnung in Ausrichtung gebracht wird und mit der Schicht aus dem leitfähigen Material und der Durchkontaktierung in elektrischen Kontakt kommt.

2. Verfahren nach Anspruch 1, welches ferner die folgenden Schritte umfasst:
Bilden einer Durchkontaktierung (22) in dem zweiten Wafer (2), welche sich von dessen vorderer Fläche (2a) aus erstreckt, wobei die Durchkontaktierung durch eine Querabmessung (221) an der vorderen Fläche (2a) **gekennzeichnet** ist;
Entfernen von Material von dem zweiten Wafer an dessen hinterer Fläche (2b);
Bilden einer Öffnung (23) in der hinteren Fläche (2b) des zweiten Wafers, wodurch die Durchkontaktierung (22) darin frei gelegt wird, wobei die Öffnung (23) eine Querabmessung aufweist, die größer als die Querabmessung (221) der Durchkontaktierung (22) ist;
Bilden einer Schicht aus leitfähigem Material (24) in der Öffnung;
Bereitstellen eines dritten Wafers (3), welcher eine vordere Fläche (3a) aufweist, wobei der dritte Wafer Einheiten aufweist, die darin in Nachbarschaft zu dessen vorderer Fläche ausgebildet sind;
Bilden eines Stiftes (37) auf der vorderen Fläche (3a) des dritten Wafers;
Bilden einer Schicht aus einem Klebematerial (36) auf der vorderen Fläche (3a) des dritten Wafers, wobei die Stifte vertikal aus dieser hinaus ragen;
Ausrichten des Stiftes (37) an der Öffnung (23) in der hinteren Fläche des zweiten Wafers; und
Kleben des dritten Wafers an den zweiten Wafer unter Verwendung der Klebematerial-Schicht (36), derart, dass der Stift (37) des dritten Wafers mit der Durchkontaktierung (22) des zweiten Wafers, mit dem Stift (27) des zweiten Wafers und mit der Durchkontaktierung (12) des ersten Wafers in elektrischen Kontakt kommt.

3. Verfahren nach Anspruch 1 oder 2, **dadurch gekennzeichnet, dass** der Schritt des Entfernens von Material dazu führt, dass der Wafer eine Dicke von weniger als 20 µm aufweist.

4. Verfahren nach Anspruch 1 oder 2, welches ferner den Schritt des Anbringens einer Handhabungsplatte (15) an der vorderen Fläche (1a) des ersten Wafers (1) unter Verwendung einer Klebematerial-Schicht (16) umfasst.

5. Verfahren nach einem der vorhergehenden Ansprüche, welches ferner den Schritt des Bildens eines leitfähigen Körpers (102) entweder in dem ersten Wafer (1) oder in dem zweiten Wafer (2) und des Verbindens desselben mit der Durchkontaktierung (12/22) in dem Wafer umfasst, wobei sich der leitfähige Körper seitlich unter den Einheiten des Wafers erstreckt, und welches **dadurch gekennzeichnet ist, dass** die Öffnung (103) in der hinteren Seite des Wafers seitlich entsprechend der seitlichen Ausdehnung des leitfähigen Körpers (102) von der Durchkontaktierung getrennt ist.

6. Verfahren nach einem der vorhergehenden Ansprüche, welches ferner die folgenden Schritte umfasst:
Bilden einer zusätzlichen Öffnung (113) in der hinteren Fläche des ersten Wafers;
Bilden einer zusätzlichen Schicht aus leitfähigem Material (114) in der zusätzlichen Öffnung;
Bilden eines zusätzlichen Stiftes (127) auf der vorderen Fläche des zweiten Wafers; und
Ausrichten des zusätzlichen Stiftes (127) an der zusätzlichen Öffnung (113) in der hinteren Fläche des ersten Wafers;
und welches **dadurch gekennzeichnet ist, dass** durch den Schritt des Klebens des zweiten Wafers an den ersten Wafer eine Verbindung zwischen dem zusätzlichen Stift (127) und der zusätzlichen Schicht aus leitfähigem Material (114) zum Leiten von Wärme zwischen dem zweiten Wafer und dem ersten Wafer gebildet wird.

7. Verfahren nach Anspruch 6, **dadurch gekennzeichnet, dass** die zusätzliche Schicht aus leitfähigem Material (114) von der Durchkontaktierung (12) elektrisch isoliert ist.

8. Verfahren nach Anspruch 2, welches ferner die folgenden Schritte umfasst:
Bilden einer zusätzlichen Öffnung in der hinteren Fläche des zweiten Wafers;
Bilden einer zusätzlichen Schicht aus leitfähigem Material in der zusätzlichen Öffnung;
Bilden eines zusätzlichen Stiftes auf der vorderen Fläche des dritten Wafers; und
Ausrichten des zusätzlichen Stiftes an der zusätzlichen Öffnung in der hinteren Fläche des zweiten Wafers; und welches **dadurch gekennzeichnet ist, dass** durch den Schritt des Klebens des dritten Wafers an den zweiten Wafer eine Verbindung zwischen dem zusätzlichen Stift und der zusätzlichen Schicht aus leitfähigem Material zum Leiten von Wärme zwischen dem dritten Wafer und dem zweiten Wafer gebildet wird.

9. Verfahren nach einem der vorhergehenden Ansprüche, **dadurch gekennzeichnet, dass** es sich bei dem Klebematerial um ein thermoplastisches Material handelt.

10. Verfahren nach einem der Ansprüche 1 bis 9, welches ferner den Schritt des Anbringens der dreidimensionalen integrierten Einheit (100) an einem Multichipmodul (300) umfasst.

## Revendications

1. Procédé de fabrication d'un dispositif intégré tridimensionnel, comprenant une pluralité de tranches empilées verticalement et interconnectées, le procédé comprenant les étapes consistant à :
fournir une première tranche (1) ayant une surface avant (1a) et une surface arrière (1b), la première tranche comprenant des dispositifs formés dans une région (1d) adjacente à sa surface avant ;
former dans la première tranche une traversée (12) aveugle, s'étendant à partir de la surface avant, la traversée ayant une dimension latérale (121) à la surface avant ;
enlever du matériau de la première tranche, à sa surface arrière (1b) ;
former une ouverture (13) dans la surface arrière de la première tranche, de manière à exposer ladite traversée (12), l'ouverture ayant une dimension latérale supérieure à ladite dimension latérale de la traversée ;
former une couche de matériau conducteur (14) dans ladite ouverture, établissant un contact électrique avec ladite traversée ;
fournir une deuxième tranche (2), ayant une surface avant (2a) et une surface arrière (2b), la deuxième tranche comprenant des dispositifs formés en son sein, de manière adjacente à sa surface avant ;
former un téton (27) sur la surface avant de la deuxième tranche ;
former une couche de matériau de liaison (26) sur la surface avant (2a) de la deuxième tranche, les tétons faisant saillie verticalement à travers elle ;
aligner le téton (27) et l'ouverture (13) dans la surface arrière de la première tranche ; et
relier la deuxième tranche à la première tranche, en utilisant la couche de matériau de liaison (26), de manière que le téton soit mis en coïncidence avec la dite ouverture et établisse un contact électrique avec ladite couche de matériau conducteur et ladite traversée.

2. Procédé selon la revendication 1, comprenant en outre les étapes consistant à :
former dans la deuxième tranche (2) une traversée (22) s'étendant à partir de sa surface avant (2a), la traversée étant **caractérisée par** une dimension latérale (221) à la surface avant (2a) ;
enlever du matériau de la deuxième tranche, à sa surface arrière (2b) ;
former une ouverture (23) dans la surface arrière (2b) de la deuxième tranche, de manière à y exposer ladite traversée (22), ladite ouverture (23) ayant une dimension latérale supérieure à ladite dimension latérale (221) de la traversée (22) ;
former une couche de matériau conducteur (24) dans ladite ouverture ;
fournir une troisième tranche (3), ayant une surface avant (3a), la troisième tranche comprenant des dispositifs formés en son sein, de manière adjacente à sa surface avant ;
former un téton (37) sur la surface avant (3a) de la troisième tranche ;
former une couche de matériau de liaison (36) sur la surface avant (3a) de la troisième tranche, les tétons faisant saillie verticalement à partir d'elle ;
aligner le téton (37) et l'ouverture (23) dans la surface arrière de la deuxième tranche ; et
relier la troisième tranche à la deuxième tranche, en utilisant la couche de matériau de liaison (36), de manière que le téton (37) de la troisième tranche établisse un contact électrique avec la traversée (22) de la deuxième tranche, avec le téton (27) de la deuxième tranche, et avec la traversée (12) de la première tranche.

3. Procédé selon la revendication 1 ou la revendication 2, **caractérisé en ce que** ladite étape d'enlèvement de matériau fait que la tranche présente une épaisseur inférieure à 20 µm.

4. Procédé selon la revendication 1 ou la revendication 2, comprenant en outre l'étape d'attachement d'une plaque de manipulation (15) à la surface avant (1a) de la première tranche (1), en utilisant une couche de matériau de liaison (16).

5. Procédé selon l'une quelconque des revendications précédentes, comprenant en outre l'étape de formation d'un corps conducteur (102) dans l'une de la première tranche (1) et de la deuxième tranche (2), et de connexion à la traversée (12/22) dans la tranche, le corps conducteur s'étendant latéralement sous les dispositifs de la tranche, et **caractérisé en ce que** l'ouverture (103) située dans la face arrière de la tranche est séparée latéralement de la traversée, selon l'étendue latérale du corps conducteur (102).

6. Procédé selon l'une quelconque des revendications précédentes, comprenant en outre les étapes consistant à :
former une ouverture additionnelle (113) dans la surface arrière de la première tranche ;
former une couche additionnelle de matériau conducteur (114) dans ladite ouverture additionnelle ;
former un téton additionnel (127) sur la surface avant de la deuxième tranche ; et
aligner le téton additionnel (127) vis-à-vis de l'ouverture additionnelle (113) située dans la surface arrière de la première tranche ;
et **caractérisé en ce que** ladite étape de liaison de la deuxième tranche à la première tranche forme une connexion entre le téton additionnel (127) et la couche additionnelle de matériau conducteur (114), pour conduire de la chaleur entre la deuxième tranche et la première tranche.

7. Procédé selon la revendication 6, **caractérisé en ce que** la couche additionnelle de matériau conducteur (114) est isolée électriquement vis-à-vis de la traversée (12).

8. Procédé selon la revendication 2, comprenant en outre les étapes consistant à :
former une ouverture additionnelle dans la surface arrière de la deuxième tranche ;
former une couche additionnelle de matériau conducteur dans ladite ouverture additionnelle ;
former un téton additionnel sur la surface avant de la troisième tranche ; et
aligner le téton additionnel et l'ouverture additionnelle dans la surface arrière de la deuxième tranche ;
et **caractérisé en ce que** ladite étape de liaison de la troisième tranche à la deuxième tranche forme une connexion entre le téton additionnel et la couche additionnelle de matériau conducteur, pour conduire de la chaleur entre la troisième tranche et la deuxième tranche.

9. Procédé selon l'une quelconque des revendications précédentes, **caractérisé en ce que** ledit matériau de liaison est un matériau thermoplastique.

10. Procédé selon l'une quelconque des revendications 1 à 9, comprenant en outre l'étape d'attachement du dispositif intégré (100) tridimensionnel à un module multi-puces (300).
